# EUROPÄISCHE PATENTSCHRIFT

(11) **EP 3 816 643 B1**
(45) Veröffentlichungstag und Bekanntmachung des Hinweises auf die Patenterteilung: **18.10.2023**
(21) Anmeldenummer: 20204312.1
(22) Anmeldetag: 28.10.2020
(51) Int. Cl.: G01R 31/28

(54) **VERBINDUNGSSYSTEM, VERFAHREN UND VERWENDUNG EINES VERBINDUNGSSYSTEMS**
CONNECTION SYSTEM, METHOD AND USE OF A CONNECTION SYSTEM
SYSTÈME DE LIAISON, PROCÉDÉ ET UTILISATION D'UN SYSTÈME DE LIAISON

(30) Priorität: 31.10.2019 DE 102019007618
(43) Veröffentlichungstag der Anmeldung: 05.05.2021
(73) Patentinhaber: Yamaichi Electronics Deutschland GmbH, 85609 Aschheim-Dornach (DE)
(72) Erfinder: Btahri, Jemei, 4000 Sousse (TN); Quiter, Michael, 57482 Wenden (DE); Serna, Yoann, 6511 Zams (AT)
(74) Vertreter: Müller-Boré & Partner Patentanwälte PartG mbB

(56) Entgegenhaltungen:
- WO-A1-2004/017076
- DE-A1-102005 057 508
- DE-A1-102011 014 148
- JP-B2- 5 066 193
- KR-B1- 102 033 560
- US-A1- 2003 197 521
- US-A1- 2004 018 048
- US-A1- 2009 102 457
- US-A1- 2010 117 673

## Beschreibung

Die Erfindung betrifft ein Verbindungssystem für einen Testhandler, insbesondere einen Halbleitertesthandler, eine Verwendung eines Testhandlers, ein Verfahren zum Verbinden eines Testhandlers und ein Verfahren zum Testen einer elektrischen Einheit mittels des Verbindungssystems.

Testhandler bzw. Test-Handhabungssysteme, insbesondere Halbleitertesthandler zum Testen von Halbleitern, weisen einen Tester bzw. eine Testvorrichtung auf, der bzw. die mittels eines Handlers bzw. Handhabungssystems mit einer zu testenden elektrischen Einheit elektrisch verbunden wird. Im verbundenen Zustand von Tester und Handler kann somit die zu testende elektrische Einheit durch den Tester getestet werden. Für gewöhnlich kommen Testhandler zum Testen von großen und schweren elektrischen Einheiten bzw. Systemen zum Einsatz, da der Testhandler die Handhabbarkeit dieser elektrischen Einheiten erhöht, beispielsweise durch Anordnen der zu testenden Einheit an dem Tester. Ferner ermöglicht der Testhandler ein elektrisches Verbinden der zu testenden elektrischen Einheit mit dem Tester.

Bei herkömmlichen Testhandlern gestaltet sich der Wechsel der zu testenden elektrischen Einheit jedoch schwierig. Zum einen muss bei einem Wechsel der elektrischen Einheit durch eine nicht baugleiche Einheit der Tester umgerüstet werden, um die neue elektrische Einheit zu unterstützen. Ferner muss der Handler gegen einen neuen Handler getauscht werden, welcher eine neue zu testende elektrische Einheit trägt. Die oben genannten Maßnahmen führen zu langen Umrüstzeiten des Testhandlers bei einem Wechsel der zu testenden elektrischen Einheit.

Ferner betrifft die US 2009/102457 A1 ein automatisiertes Testgerät-Schnittstellensystem, z. B. zum Anbringen eines Handlers an einem Testkopf. Das Testgerät umfasst eine Geräteschnittstellenplatinenanordnung. Die Geräteschnittstellenplatinenanordnung umfasst einen Versteifungsrahmen mit einem Rahmenkörper, der zur Befestigung an einem Prüfkopf konfiguriert ist, mit dem Rahmenkörper verbundene Ausrichtungshalterungen und mit den Ausrichtungshalterungen verbundene Nockenfolger. Das System umfasst auch eine Andockvorrichtung. Die Andockvorrichtung umfasst eine Andockplatte, die zum Anbringen an einem Handler konfiguriert ist, Herunterziehrampen, die mit der Andockplatte verbunden und zwischen einer eingefahrenen Position und einer ausgefahrenen Position bewegbar sind, einen Aktuator, der betreibbar ist, um eine Bewegung der Herunterziehrampen einzuleiten, und eine Kupplung, die die Bewegung des Aktuators in entsprechende Bewegungen der Herunterziehrampen übersetzt.

Die DE 10 2011 014148 A1 betrifft eine Dockingvorrichtung zur Verbindung eines Halbleiter-Testkopfs mit einem Halbleiter-Handler. Diese hat eine testkopfseitige und eine handlerseitige Verbindungsvorrichtung, eine Handhabungsvorrichtung zum Handhaben einer Kontaktierungsvorrichtung und eine Koppelvorrichtung zum Koppeln der Verbindungsvorrichtungen. Die Koppelvorrichtung weist eine erste Verschiebeeinrichtung auf, die das translatorische und geführte Verschieben der testkopfseitigen Verbindungsvorrichtung relativ zur handlerseitigen Verbindungsvorrichtung aufeinander zu und voneinander weg erlaubt.

Die US 2004/018048 A1 betrifft ein pneumatisches Andocksystem.

Die DE 10 2005 057508 A1 betrifft eine Dockingvorrichtung zum Kuppeln einer aus einem Handler oder Prober bestehenden Handhabungsvorrichtung mit einem Testkopf für elektronische Bauelemente, an dem ein DUT-Board befestigt ist. Bei dieser Dockingvorrichtung sind handhabungsvorrichtungsseitige Verriegelungselemente und testkopfseitige Verriegelungselemente vorhanden, die miteinander in zentrierten Verriegelungseingriff bringbar sind.

Die JP 5 066193 B2 betrifft eine Verbinderhaltevorrichtung, die mit einem Paar Verbinder, die ineinander in Eingriff gebracht werden können, einem Halteelement, das einen Verbinder in einem Paar Verbinder hält, und einem Energieversorgungsmittel versehen ist.

Die US 2010/117673 A1 betrifft ein Wafertestausrüstungssystem.

Die US 2003/197521 A1 betrifft einen abnehmbarer Schnittstellenadapter. Dieser umfasst einen Rahmen, einen ersten Satz von Kontakten, der für die Verbindung mit einem ersten Satz von Testkopfkontakten in einem Testsystem konfiguriert ist, und einen zweiten Satz von Kontakten, der für den Anschluss an eine Testplatine mit mindestens einem zu testenden Gerät konfiguriert ist.

Es ist daher Aufgabe der Erfindung eine Verbindungseinheit für einen Tester bereitzustellen, welche einen einfachen Aufbau aufweist und eine sichere Verbindung zu einer handlerseitigen Verbindungseinheit ermöglicht.

Ferner ist es Aufgabe der vorliegenden Erfindung, ein Verbindungssystem für einen Testhandler, insbesondere einen Halbleitertesthandler, welches eine schnelle Umrüstung des Testhandlers ermöglicht, eine entsprechende Verwendung und ein entsprechendes Verfahren, bereitzustellen.

Diese Aufgabe wird durch die Gegenstände der unabhängigen Ansprüche gelöst. Bevorzugte Ausführungsformen sind in den abhängigen Ansprüchen definiert.

Ein Aspekt der Erfindung betrifft ein Verbindungssystem für einen Testhandler, insbesondere einen Halbleitertesthandler, aufweisend: eine testerseitige Verbindungseinheit zur Anordnung an einem Tester, eine handlerseitige Verbindungseinheit zur Anordnung an einem Handler, wobei die testerseitige Verbindungseinheit und die handlerseitige Verbindungseinheit miteinander verbindbar sind, wobei die handlerseitige Verbindungseinheit aufweist: einen handlerseitigen Rahmen, der eine Vielzahl von handlerseitigen Eingriffelementen aufweist, wobei die testerseitige Verbindungseinheit aufweist: einen ersten testerseitigen Rahmen, der eine Vielzahl von testerseitigen Eingriffelementen aufweist, welche dazu ausgelegt ist, mit der Vielzahl von handlerseitigen Eingriffelementen in Eingriff zu gelangen, wobei die Vielzahl von testerseitigen Eingriffelementen beweglich an dem ersten testerseitigen Rahmen ausgebildet ist, und wobei zum Verbinden des Verbindungssystems, die Vielzahl von testerseitigen Eingriffelementen derart führbar ist, dass die Vielzahl von testerseitigen Eingriffelementen mit der Vielzahl von handlerseitigen Eingriffelementen in Eingriff gelangt.

Vorteilhafter Weise ermöglicht die Vielzahl von testerseitigen Eingriffelementen, welche mit der Vielzahl von handlerseitigen Eingriffelement in Eingriff gelangen kann, dass im verbundenen Zustand von Tester und Handler, der Handler sicher an dem Tester gehalten wird.

Insbesondere kann die testerseitige Verbindungseinheit dazu ausgebildet sein, eine testerseitige Leiterplatte aufzunehmen, welche mit einer an der handlerseitigen Verbindungseinheit angeordneten handlerseitigen Leiterplatte kontaktierbar, insbesondere elektrisch kontaktierbar ist. Ferner können die handlerseitige Leiterplatte und die testerseitige Leiterplatte im verbundenen Zustand des Verbindungssystems bzw. im verbundenen Zustand von testerseitiger Verbindungseinheit und handlerseitiger Verbindungseinheit sich kontaktieren, insbesondere elektrisch kontaktieren. Die elektrische Kontaktierung ermöglicht insbesondere das elektrische Testen einer an dem Handler angeordneten elektrischen Einheit, welche vorzugsweise mit der handlerseitigen Leiterplatte elektrisch verbunden ist. Beispiele für eine an dem Handler anordenbare elektrische Einheit umfassen einen Mikroprozessor, einen Speicherchip oder einen elektrischen Sensor. Allerdings sind elektrische Einheiten nicht auf diese Beispiele begrenzt.

Insbesondere ist die handlerseitige Verbindungseinheit dazu ausgebildet, dass die zu testende elektrische Einheit die handlerseitige Leiterplatte kontaktiert, insbesondere elektrische kontaktiert.

So ermöglichen auf vorteilhafter Weise die testerseitigen Eingriffelemente und die handlerseitigen Eingriffelemente, dass im verbundenen Zustand, zwischen der testerseitigen Leiterplatte und der handlerseitigen Leiterplatte, eine sichere elektrische Verbindung hergestellt ist, so dass die elektrische Einheit einem Funktionstest unterzogen werden kann.

Insbesondere werden die testerseitige Verbindungseinheit und die handlerseitige Verbindungseinheit miteinander verbunden, indem die handlerseitige Verbindungseinheit entlang einer Verbindungsrichtung auf die testerseitige Verbindungseinheit hinzu bewegt wird. Dabei steht die Verbindungsrichtung im Wesentlichen senkrecht zu einer Bezugsebene, die durch den handlerseitigen Rahmen gebildet wird. Ferner können der handlerseitige Rahmen und der erste testerseitige Rahmen im verbundenen Zustand gegenüberliegend angeordnet sein. Insbesondere können im verbundenen Zustand eine durch den ersten testerseitigen Rahmen aufgespannte Bezugsebene und die durch den handlerseitigen Rahmen aufgespannte Bezugsebene im Wesentlichen parallel zueinander stehen.

Ferner kann die Vielzahl von testerseitigen Eingriffelementen zum Verbinden des Verbindungssystems im Wesentlichen parallel zur Bezugsebene, welche durch den ersten testerseitigen Rahmen aufgespannt wird, bewegt werden. Die Vielzahl von testerseitigen Eingriffelementen kann beispielsweise zwei Eingriffelemente aufweisen, bevorzugt vier Eingriffelemente und besonders bevorzugt sechs Eingriffelemente aufweisen. Ferner kann der erste testerseitige Rahmen eine im Wesentlichen rechteckige Form aufweisen, und aus vier länglich ausgebildeten Rahmenabschnitten bestehen, welche um eine Rahmenöffnung herum angeordnet sind.

Die Rahmeneröffnung ermöglicht es, dass im verbundenen Zustand, die testerseitige Leiterplatte die handlerseitige Leiterplatte elektrisch kontaktieren kann, sodass zwischen der testerseitigen Leiterplatte und der handlerseitigen Leiterplatte eine elektrische Verbindung hergestellt werden kann. Vorteilhafter Weise kann somit der Tester mit der zu testenden elektrischen Einheit elektrisch verbunden werden.

Ferner kann die Vielzahl von testerseitigen Eingriffelementen auf zwei sich gegenüberliegenden Rahmenabschnitten des testerseitigen Rahmens angeordnet sein. So können beispielsweise bei insgesamt vier testerseitigen Eingriffelementen, zwei testerseitige Eingriffelemente auf einem ersten Rahmenabschnitt des ersten testerseitigen Rahmens angeordnet sein und die anderen zwei testerseitigen Eingriffelemente können auf einem zweiten Rahmenabschnitt angeordnet sein, der dem ersten Rahmenabschnitt in Bezug auf einen Mittelpunkt des ersten testerseitigen Rahmens gegenüberliegt.

Ferner ist die testerseitige Verbindungseinheit dazu ausgebildet, dass zum Verbinden des Verbindungssystem die Vielzahl von testerseitigen Eingriffelementen in die gleiche Richtung bewegbar bzw. führbar ist. Insbesondere können an dem ersten testerseitigen Rahmen Schienenelemente angeordnet sein, wobei die testerseitigen Eingriffelemente beweglich an dem Schienenelement angeordnet sind. Vorzugsweise ermöglicht das Anordnen der testerseitigen Eingriffelemente auf den Schienenelementen, dass die testerseitigen Eingriffelemente sicher geführt werden können und somit eine stabile Verbindung des Verbindungssystems gewährleistet ist.

Jedes Eingriffelement der Vielzahl von testerseitigen Eingriffelementen kann insbesondere als Haken ausgebildet sein, das mit einem entsprechenden Eingriffelement der Vielzahl von handlerseitigen Eingriffelementen in Eingriff gelangen kann. Ferner können die handlerseitigen Eingriffelemente als Bolzen ausgebildet sein, in die ein Haken eingreifbar ist.

Ferner kann der handlerseitige Rahmen eine im Wesentlichen rechteckige Form aufweisen. Des Weiteren kann der handlerseitige Rahmen eine Rahmenöffnung aufweisen, die es wie oben beschrieben ermöglicht, dass im verbundenen Zustand, die testerseitige Leiterplatte die handlerseitige Leiterplatte kontaktiert, insbesondere elektrisch kontaktiert. Des Weiteren kann der handlerseitige Rahmen aus vier länglich ausgebildeten Rahmenabschnitten bestehen.

Entsprechend der Anordnungsposition der Vielzahl von testerseitigen Eingriffelementen, ist die Vielzahl von handlerseitigen Eingriffelementen an entsprechenden Anordnungspositionen des handlerseitigen Rahmens angeordnet.

Das Verbindungssystem bzw. die testerseitige Verbindungseinheit weist einen zweiten testerseitigen Rahmen auf, der gegenüber dem ersten testerseitigen Rahmen verschiebbar ausgebildet ist, wobei die Vielzahl von testerseitigen Eingriffelementen durch den zweiten testerseitigen Rahmen führbar ist, und wobei zum Verbinden des Verbindungssystems, der zweite testerseitige Rahmen in eine Sicherungsposition bewegbar ist und die Vielzahl von testerseitigen Eingriffelementen mittels des zweiten testerseitigen Rahmens derart führbar ist, dass die Vielzahl von testerseitigen Eingriffelementen mit der Vielzahl von handlerseitigen Eingriffelementen in Eingriff gelangt.

Vorteilhafter Weise ermöglicht der zweite testerseitige Rahmen, dass die Vielzahl von testerseitigen Eingriffelementen gleichmäßig geführt wird, um in Eingriff mit der Vielzahl von handlerseitigen Eingriffelementen zu gelangen. Des Weiteren ermöglicht der zweite testerseitige Rahmen, dass die Vielzahl von testerseitigen Eingriffelementen durch den zweiten testerseitigen Rahmen stabilisiert und unterstützt wird. Insbesondere kann der zweite testerseitige Rahmen ein Kippen der Vielzahl von testerseitigen Eingriffelementen verhindern. Im verbundenen Zustand des Verbindungssystems ist der zweite testerseitige Rahmen zwischen dem ersten testerseitigen Rahmen und dem handlerseitigen Rahmen angeordnet. Ferner kann der zweite testerseitige Rahmen ebenfalls eine Rahmenöffnung umfassen, die es ermöglicht, die testerseitige Leiterplatte mit der handlerseitigen Leiterplatte zu kontaktieren, insbesondere elektrisch zu kontaktieren. Ferner kann der zweite testerseitige Rahmen eine im Wesentlichen rechteckige Form aufweisen, welche durch vier länglich ausgebildete Rahmenabschnitte gebildet ist.

Des Weiteren ist der zweite testerseitige Rahmen dem ersten testerseitigen Rahmen gegenüberliegend angeordnet, sodass die durch den ersten testerseitigen Rahmen und den zweiten testerseitigen Rahmen jeweilig aufgespannten Bezugsebenen parallel zueinander liegen.

Vorzugsweise weist der handlerseitige Rahmen ein handlerseitiges Führungsmittel auf, welches beim Verbinden des Verbindungssystems in ein an der testerseitigen Verbindungseinheit angeordnetes testerseitiges Führungselement einführbar ist.

Vorzugsweise ermöglicht das handlerseitige Führungsmittel und das testerseitige Führungselement, dass der Handler bzw. die handlerseitige Verbindungseinheit sicher und zielgenau an den Tester bzw. an die testerseitige Verbindungseinheit herangeführt werden kann. Das handlerseitige Führungsmittel kann beispielsweise an dem handlerseitigen Rahmen ausgebildet sein und eine bolzenförmige Form aufweisen, welche sich in Verbindungsrichtung erstreckt. An einer korrespondierenden Position des ersten testerseitigen Rahmens kann das testerseitige Führungselement ausgebildet sein, beispielsweise als eine Buchse, in die das bolzenförmige Führungsmittel einführbar ist.

Vorzugsweise weist die testerseitige Verbindungseinheit ein Hebelelement auf, welches dazu ausgebildet ist, den zweiten testerseitigen Rahmen gegenüber dem ersten testerseitigen Rahmen zu verschieben.

Vorteilhafter Weise ermöglicht das Hebelelement, ein Bewegen des zweiten testerseitigen Rahmens gegenüber dem ersten testerseitigen Rahmen ohne großen Kraftaufwand, wodurch das Verbinden des Verbindungssystems vereinfacht wird. Ferner kann zum Verbinden des Verbindungssystems der Hebel in eine entsprechende Sicherungsposition bewegt werden, bei dem die testerseitige Verbindungseinheit mit der handlerseitigen Verbindungseinheit verbunden wird, insbesondere führt das Bewegen des Hebels in die Sicherungsposition dazu, dass die Vielzahl von testerseitigen Eingriffelementen mit der Vielzahl von handlerseitigen Eingriffelementen in Eingriff gelangt. Insbesondere kann das Hebelelement als Kniehebel ausgebildet sein, welcher den ersten testerseitigen Rahmen mit dem zweiten testerseitigen Rahmen verbindet.

Vorzugsweise weist die testerseitige Verbindungseinheit eine Vielzahl von testerseitigen Verbindungselementen auf, die dazu ausgelegt ist, die testerseitige Verbindungseinheit mit einem Tester zu verbinden.

Vorteilhafter Weise ermöglicht die Vielzahl von Verbindungselementen ein schnelles Verbinden und Lösen der testerseitigen Verbindungseinheit mit und von dem Tester, wodurch die Wartungsfreundlichkeit des Testers erhöht wird. Insbesondere kann jedes der Verbindungselemente der Vielzahl von Verbindungselementen als klickbarer Schnellverbinder ausgebildet sein.

Vorzugsweise ist die testerseitige Verbindungseinheit dazu ausgelegt, eine testerseitige Leiterplatte aufzunehmen und die handlerseitige Verbindungseinheit dazu ausgelegt, eine handlerseitige Leiterplatte aufzunehmen, wobei im verbundenen Zustand des Verbindungssystems, die testerseitige Leiterplatte und die handlerseitige Leiterplatte sich elektrisch kontaktieren.

Vorzugsweise weist das Verbindungssystem bzw. die testerseitige Verbindungseinheit ein testerseitiges Versteifungselement auf, welches an dem ersten testerseitigen Rahmen angeordnet ist und dazu ausgelegt ist, die testerseitige Leiterplatte aufzunehmen.

Vorteilhafter Weise erhöht das Versteifungselement die Steifigkeit des ersten testerseitigen Rahmens, sodass eine hohe physikalische Stabilität und Belastbarkeit gewährleistet ist. Insbesondere kann das Versteifungselement eine im Wesentlichen rechteckige Form sowie eine im Wesentlichen gitterförmige Struktur aufweisen. Des Weiteren erstreckt sich das Versteifungselement mindestens über zwei sich gegenüberliegende Rahmenabschnitte des ersten testerseitigen Rahmens. Ferner kann das Versteifungselement derart an dem ersten testerseitigen Rahmen angeordnet sein, sodass der erste testerseitige Rahmen zwischen dem Versteifungselement und dem zweiten testerseitigen Rahmen angeordnet ist. Insbesondere kann das Versteifungselement an einer Seite des ersten testerseitigen Rahmens angeordnet sein, die im verbundenen Zustand von der handlerseitigen Verbindungseinheit abgewandt ist.

Vorzugsweise ist die Vielzahl von testerseitigen Eingriffelementen derart ausgebildet, dass beim Verbinden des Verbindungssystems, die handlerseitige Verbindungseinheit an die testerseitige Verbindungseinheit heranziehbar ist.

Vorteilhafter Weise ermöglicht diese Ausgestaltung, dass die handlerseitige Verbindungseinheit in einer ersten Phase des Verbindens der handlerseitigen Verbindungseinheit mit der testerseitigen Verbindungseinheit einfach an die testerseitige Verbindungseinheit herangeführt werden kann. Insbesondere kann in der ersten Phase die Vielzahl von handlerseitigen Eingriffelementen einfach in die Vielzahl von testerseitigen Eingriffelementen eingeführt werden. In einer Endphase des Verbindens, kann dann die handlerseitige Verbindungseinheit sicher an die testerseitige Verbindungseinheit herangeführt werden, sodass es zu einem sicheren Kontaktschluss zwischen der testerseitigen Leiterplatte unter der handlerseitigen Leiterplatte kommt.

Insbesondere kann jedes Eingriffelement der Vielzahl von testerseitigen Eingriffelementen als Haken ausgebildet sein, der eine sich verjüngende Öffnung aufweist.

Ein Aspekt der Erfindung betrifft eine Verbindungseinheit für einen Testhandler, insbesondere einen Halbleitertesthandler, zum Verbinden mit einer handlerseitigen Verbindungseinheit, aufweisend: einen ersten testerseitigen Rahmen, der eine Vielzahl von testerseitigen Eingriffelementen aufweist, welche dazu ausgelegt ist, mit einer Vielzahl von handlerseitigen Eingriffelementen in Eingriff zu gelangen, wobei die Vielzahl von testerseitigen Eingriffelementen beweglich an dem ersten testerseitigen Rahmen ausgebildet ist, und wobei zum Verbinden der testerseitigen Verbindungseinheit mit der handlerseitigen Verbindungseinheit, die Vielzahl von testerseitigen Eingriffelementen derart führbar ist, dass die Vielzahl von testerseitigen Eingriffelementen mit der Vielzahl von handlerseitigen Eingriffelementen in Eingriff gelangt.

Vorzugsweise weist die testerseitige Verbindungseinheit einen zweiten testerseitigen Rahmen auf, der gegenüber dem ersten testerseitigen Rahmen verschiebbar ausgebildet ist, wobei die Vielzahl von testerseitigen Eingriffelementen durch den zweiten testerseitigen Rahmen führbar ist, wobei zum Verbinden der testerseitigen Verbindungseinheit mit der handlerseitigen Verbindungseinheit, der zweite testerseitige Rahmen in eine Sicherungsposition bewegbar ist und die Vielzahl von testerseitigen Eingriffelementen mittels des zweiten testerseitigen Rahmen derart führbar ist, dass die Vielzahl von testerseitigen Eingriffelementen mit der Vielzahl von handlerseitigen Eingriffelementen in Eingriff gelangt.

Ferner kann die Verbindungseinheit entsprechend der zuvor beschriebenen testerseitigen Verbindungseinheit ausgebildet werden.

Ein weiterer Aspekt der Erfindung betrifft eine Verwendung eines zuvor beschriebenen Verbindungssystems.

Ein weiterer Aspekt der Erfindung betrifft ein Verfahren zum Verbinden eines Testhandlers, insbesondere eines Halbleitertesthandlers, mittels eines zuvor beschriebenen Verbindungssystems, aufweisend: Anordnen der handlerseitigen Verbindungseinheit an der testerseitigen Verbindungseinheit, und Führen der Vielzahl von testerseitigen Eingriffelementen derart, dass die Vielzahl von testerseitigen Eingriffelementen mit der Vielzahl von handlerseitigen Eingriffelementen in Eingriff gelangt.

Ein weiterer Aspekt der Erfindung betrifft ein Verbindungssystem für einen Testhandler, insbesondere einen Halbleitertesthandler, aufweisend: eine testerseitige Verbindungseinheit zur Anordnung an einem Tester, wobei die testerseitige Verbindungseinheit dazu ausgelegt ist, eine testerseitige Leiterplatte aufzunehmen, eine handlerseitige Verbindungseinheit zur Anordnung an einem Handler, wobei die testerseitige Verbindungseinheit und die handlerseitige Verbindungseinheit miteinander verbindbar sind, wobei die handlerseitige Verbindungseinheit dazu ausgelegt ist, eine handlerseitige Leiterplatte aufzunehmen, wobei die handlerseitige Leiterplatte in einem verbundenen Zustand der testerseitigen Verbindungseinheit mit der handlerseitigen Verbindungseinheit, die testerseitige Leiterplatte elektrisch kontaktiert, und wobei die handlerseitige Leiterplatte dazu ausgebildet ist, die testerseitige Leiterplatte mit einer an dem Handler angeordneten zu testenden ersten elektrischen Einheit elektrisch zu verbinden.

Vorzugsweise ermöglicht das vorgeschlagene Verbindungssystem, einen Testhandler derart zu verbinden, dass der Tester eine an dem Handler angeordnete zu testende erste elektrische Einheit testen kann. Insbesondere können für das Testen die testerseitige Leiterplatte und die handlerseitige Leiterplatte sich gegenseitig kontaktieren, insbesondere elektrisch kontaktieren. Insbesondere kann vorgesehen sein, dass die handlerseitige Verbindungseinheit ein Austauschen der handlerseitigen Leiterplatte ermöglicht.

Vorzugsweise ist die testerseitige Leiterplatte als eine universelle Leiterplatte ausgebildet und/oder die handlerseitige Leiterplatte ist als eine an die zu testende erste elektrische Einheit spezifisch angepasste Leiterplatte ausgebildet. Als universelle Leiterplatte wird eine Leiterplatte verstanden, welche mindestens zwei verschiedene zu testende elektrische Einheiten unterstützt. Ferner benötigt eine universelle Leiterplatte keine Anpassungen, um mit unterschiedlichen zu testenden Einheiten zu funktionieren.

Vorteilhafter Weise ermöglicht die universelle Leiterplatte, dass der Tester für andere zu testende elektrische Einheiten nicht umgerüstet werden muss. Vielmehr ist es notwendig, dass bei einem Wechsel der zu testenden elektrischen Einheit durch eine nicht baugleiche zu testende elektrische Einheit, die handlerseitige Leiterplatte durch eine an die neue zu testende Einheit angepasste Leiterplatte getauscht wird. Insbesondere kann die handlerseitige Leiterplatte dazu ausgebildet sein, eine Schnittstelle bzw. Schnittstellenfunktion zwischen der universellen testerseitigen Leiterplatte und der zu testenden elektrischen Einheit bereitzustellen.

Vorteilhafter Weise können dadurch Umrüstzeiten des Testers reduziert werden bzw. entfallen diese Umrüstzeiten, da der Tester nicht für eine neue zu testende Einheit konfiguriert werden muss. Ferner ist es möglich Handler mit dem Tester zu verbinden, welche unterschiedliche zu testende Einheiten aufweisen. Ferner wird unter "nicht baugleich" verstanden, dass die zu testenden elektrischen Einheiten unterschiedliche Konfiguration aufweisen, beispielsweise unterschiedliche Anordnungen der elektrischen Kontaktierung, unterschiedliche technische Funktionen der elektrischen Einheit, und/oder unterschiedliche elektrische Schaltungen.

Vorzugsweise ist bei einem Wechsel der zu testenden ersten elektrischen Einheit durch eine zu testende zweite elektrische Einheit, die nicht baugleich mit der ersten elektrischen Einheit ist, die handlerseitige Leiterplatte durch eine andere handlerseitige Leiterplatte austauschbar, wobei die andere handlerseitige Leiterplatte spezifisch für die zweite elektrische Einheit ausgebildet ist.

Vorzugsweise ist die handlerseitige Leiterplatte durch eine zweite handlerseitige Leiterplatte austauschbar und die zweite handlerseitige Leiterplatte ist dazu ausgebildet, die testerseitige Leiterplatte mit einer an dem Handler angeordneten zu testenden zweiten elektrischen Einheit elektrisch zu verbinden, und wobei die zweite elektrische Einheit sich von der ersten elektrischen Einheit unterscheidet.

Ein weiterer Aspekt der Erfindung betrifft eine Verwendung eines zuvor beschriebenen Verbindungssystems zum Verbinden eines Testhandlers.

Ein weiterer Aspekt der Erfindung betrifft ein Verfahren zum Testen einer elektrischen Einheit mittels eines zuvor beschriebenen Verbindungssystems, aufweisend: Anordnen der handlerseitigen Verbindungseinheit an der testerseitigen Verbindungseinheit, und Testen der ersten elektrischen Einheit.

Vorzugsweise weist das Verfahren weiter auf: Ersetzen der ersten elektrischen Einheit durch eine zweite elektrische Einheit, wobei die zweite elektrische Einheit sich von der ersten elektrischen Einheit unterscheidet, und Tauschen der handlerseitigen Leiterplatte durch eine zweite handlerseitige Leiterplatte, wobei die zweite handlerseitige Leiterplatte dazu ausgebildet ist, die testerseitige Leiterplatte mit der an dem Handler angeordneten zu testenden zweiten elektrischen Einheit elektrisch zu verbinden.

Vorzugsweise sieht das Verfahren weiter das Beibehalten der testerseitigen Leiterplatte vor.

Im Folgenden wird eine Ausführungsform der Erfindung anhand der beiliegenden Figuren näher beschrieben. Es versteht sich, dass die vorliegende Erfindung nicht auf diese Ausführungsform beschränkt ist, und dass einzelne Merkmale der Ausführungsform im Rahmen der beiliegenden Ansprüche zu weiteren Ausführungsformen kombiniert werden können.

Es zeigen:
- **Fig.** 1: eine perspektivische Ansicht eines nicht verbundenen Verbindungssystems;
- **Fig. 2**: das in Fig. 1 gezeigte Verbindungssystem aus einer zweiten Perspektive;
- **Fig. 3**: ein Versteifungselement einer testerseitigen Verbindungseinheit des Verbindungssystems;
- **Fig. 4**: das Versteifungselement aus Fig. 3 mit einem ersten testerseitigen Rahmen;
- **Fig. 5**: testerseitige Verbindungseinheit mit einem zweiten testerseitigen Rahmen;
- **Fig. 6.**: ein testerseitiges Eingriffelement; und
- **Fig. 7**: das Verbindungssystem im verbundenen Zustand.

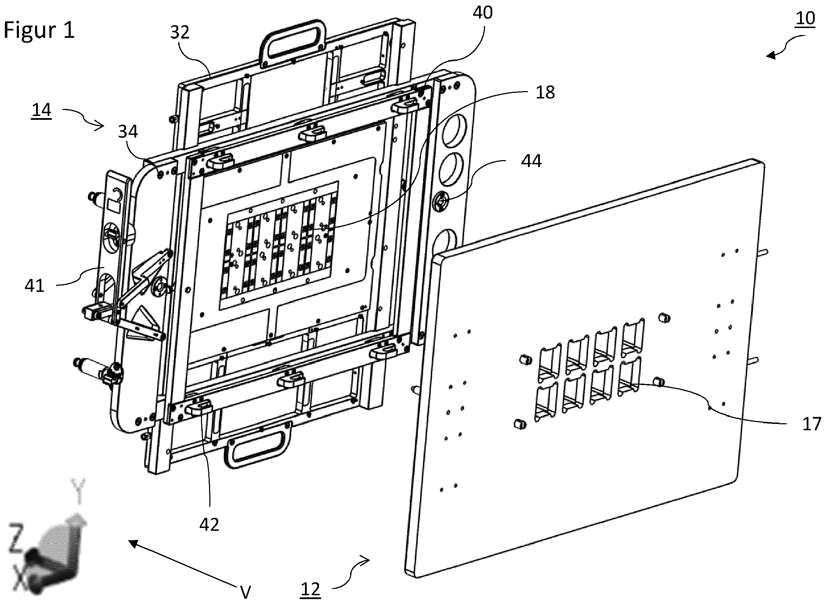

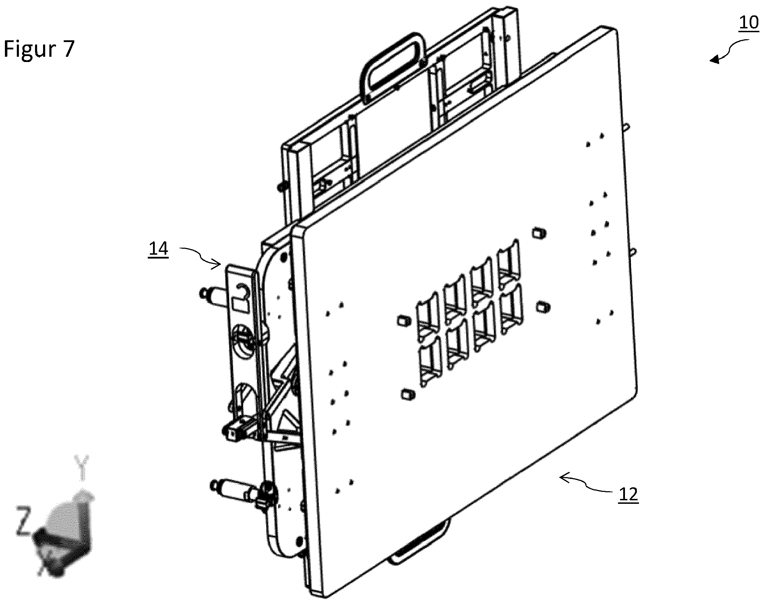

Fig. 1 zeigt eine perspektivische Ansicht eines nicht verbundenen Verbindungssystems 10 eines Testhandlers bzw. eines Test-Handhabungssystems zum Testen von elektrischen Einheiten, insbesondere Halbleiter-Einheiten. Das Verbindungssystem 10 weist eine handlerseitige Verbindungseinheit 12 und eine testerseitige Verbindungseinheit 14 auf, die miteinander verbindbar ausgebildet sind. Ein verbundener Zustand des Verbindungssystems 10 ist in Fig. 7 gezeigt, welche die handlerseitige Verbindungseinheit 12 und die testerseitige Verbindungseinheit 14 in dem verbundenen Zustand darstellt.

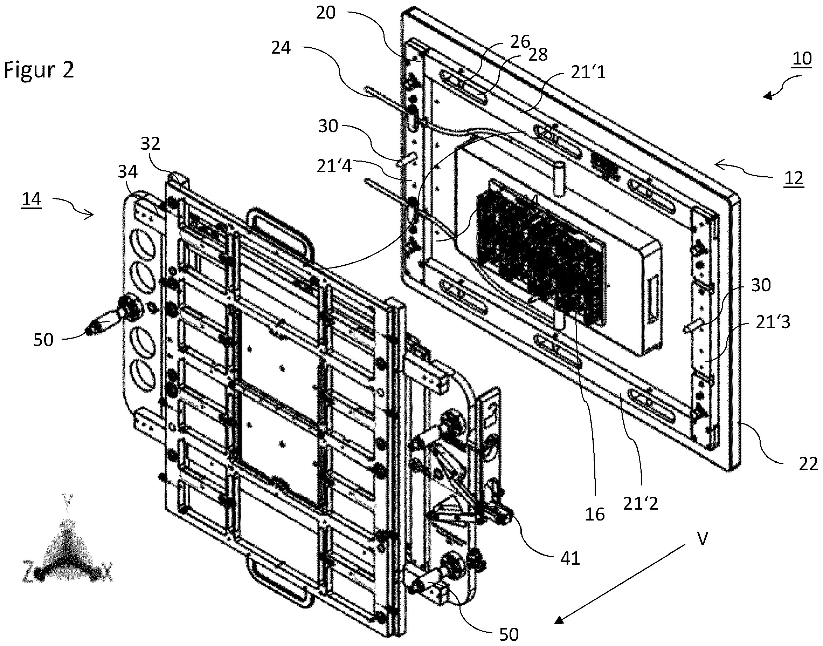

Wie in den Fig. 1 und 2 gezeigt, ist die handlerseitige Verbindungseinheit 12 dazu ausgebildet, eine handlerseitige Leiterplatte 16 aufzunehmen. Ferner ist die testerseitige Verbindungseinheit 14 dazu ausgebildet, eine testerseitige Leiterplatte 18 aufzunehmen. Die handlerseitige Leiterplatte 16 ist dazu ausgebildet, im verbundenen Zustand des Verbindungssystems 10, eine an der handlerseitigen Verbindungseinheit 12 angeordnete elektrische Einheit (nicht gezeigt) mit der testerseitigen Leiterplatte 16 zu verbinden, insbesondere elektrisch zu verbinden.

Wie in Fig. 2 gezeigt, besteht die handlerseitige Verbindungseinheit 12 aus einem handlerseitigen Rahmen 20, welcher eine Bezugsebene aufspannt, die in Fig. 2 parallel zur gezeigten X-Y-Ebene liegt. Zum Verbinden der handlerseitigen Verbindungseinheit 12 mit der testerseitigen Verbindungseinheit 14 ist die handlerseitige Verbindungseinheit 12 in Richtung der eingezeichneten Verbindungsrichtung V, welche der Z-Richtung entspricht, zu führen. Die Verbindungsrichtung V steht dabei orthogonal auf der Bezugsebene des handlerseitigen Rahmens 20 und verläuft in Richtung der testerseitigen Verbindungseinheit 14. Ferner weist der handlerseitige Rahmen 20 eine im Wesentlichen rechteckige Form auf, welche eine Rahmenöffnung umgibt, sodass im verbundenen Zustand, die handlerseitige Leiterplatte 16 die testerseitige Leiterplatte 18 kontaktieren, insbesondere elektrisch kontaktieren kann.

Ferner ist der handlerseitige Rahmen 20 an einem handlerseitigen Unterstützungselement 22 angeordnet. Das handlerseitige Unterstützungselement 22 kann die Form einer Platte aufweisen bzw. ist plattenförmig ausgebildet. Das handlerseitige Unterstützungselement 22 ist mit dem handlerseitigen Rahmen 20 verbunden. Insbesondere weist das Unterstützungselement 22 eine erste Seite auf, welche im verbundenen Zustand, der testerseitigen Verbindungseinheit 14 zugewandt ist, an der der handlerseitige Rahmen 20 angeordnet ist. Das handlerseitige Unterstützungselement 22 ist insbesondere dazu ausgebildet, den handlerseitigen Rahmen 20 zu stabilisieren bzw. zu versteifen. Ferner ist im verbundenen Zustand der handlerseitige Rahmen 20 zwischen dem Unterstützungselement 22 und der testerseitigen Verbindungseinheit 14 angeordnet.

Ferner weist das handlerseitige Unterstützungselement 22 eine Öffnung auf, in der die handlerseitige Leiterplatte 16 zumindest abschnittsweise angeordnet ist. Ferner weist das handlerseitige Unterstützungselement 22 auf einer der ersten Seite des handlerseitigen Unterstützungselements 22 gegenüberliegenden Seite des handlerseitigen Unterstützungselements 22, die im verbundenen Zustand von der testerseitigen Verbindungseinheit 14 abgewandt ist, eine Anordnungsposition 17 auf, an der die zu testende Einheit angeordnet werden kann, sodass die zu testende Einheit elektrisch mit der handlerseitigen Leiterplatte 16 verbunden ist.

Wie in Fig. 2 gezeigt, weist die handlerseitige Verbindungseinheit 12 handlerseitige elektrische Verbindungsmittel 24 auf, welche dazu ausgebildet sind, die handlerseitige Leiterplatte 16 elektrisch mit einer nicht gezeigten Spannungsversorgung und/oder nicht gezeigten Schaltungslogik zu verbinden.

Zum Verbinden der handlerseitigen Verbindungseinheit 12 mit der testerseitigen Verbindungseinheit 14, weist die handlerseitige Verbindungseinheit 12 ferner eine Vielzahl von handlerseitigen Eingriffelementen 26 auf. Wie in Fig. 2 gezeigt, ist die Vielzahl von handlerseitigen Eingriffelementen 26 an dem handlerseitigen Rahmen 20 angeordnet. Der Rahmen 20 besteht aus vier länglich ausgebildeten Rahmenabschnitten 21'1-4, die derart miteinander verbunden sind, um einen im Wesentlich reckteckförmigen handlerseitigen Rahmen 20 zu bilden. Die Vielzahl von handlerseitigen Eingriffelementen 26 ist auf zwei gegenüberliegenden Rahmenabschnitte 21'1 und 21'2 angeordnet. Beispielhaft zeigt Fig. 2 sechs handlerseitige Eingriffelemente 26, wobei jeweils drei Eingriffelemente jeweils auf den Rahmenabschnitten 21'1 und 21'2 angeordnet sind.

Jedes Eingriffelement der Vielzahl von handlerseitigen Eingriffelementen 26 ist als Bolzen ausgebildet, der in einer jeweiligen handlerseitigen Aussparung 28 des handlerseitigen Rahmens 20 angeordnet ist. D.h., die Anzahl der Aussparungen 28 entspricht der Anzahl von handlerseitigen Eingriffelementen 26.

Ferner weist die handlerseitige Verbindungseinheit 12 zwei Führungsmittel 30 auf, welche an dem handlerseitigen Rahmen 20 angeordnet sind. Die Führungsmittel 30 sind ferner bolzenförmig ausgebildet und erstrecken sich ausgehend von dem handlerseitigen Rahmen 20 in Verbindungsrichtung V. Ferner ermöglichen die Führungsmittel 30, dass beim Verbinden der handlerseitigen Verbindungseinheit 12 mit der testerseitigen Verbindungseinheit 14, die Führungsmittel 30 in an der testerseitigen Verbindungseinheit 14 entsprechend angeordnete Führungselemente 44 (siehe Figur 1) eingeführt werden, um ein gestütztes bzw. geführtes Verbinden des Verbindungssystems 10 zu ermöglichen.

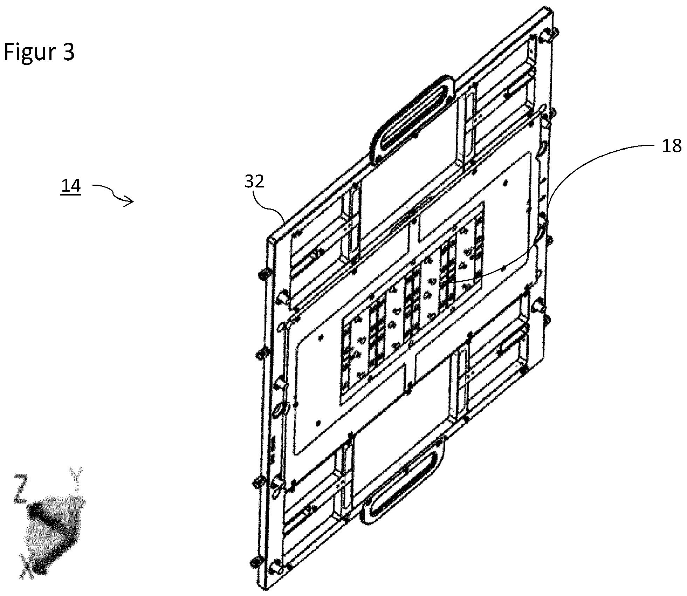

Unter Bezugnahme auf die Fig. 3-5 wird im Folgenden die testerseitige Verbindungseinheit 14 näher erläutert. Wie in Fig. 3 gezeigt besteht die testerseitige Verbindungseinheit 14 aus einem Versteifungselement 32, welches eine im Wesentlichen flache gitterförmige Struktur aufweist. Ferner ist das Versteifungselement 32 dazu ausgebildet, die testerseitige Leiterplatte 18 aufzunehmen. Ferner spannt das Versteifungselement 32 eine Bezugsebene auf, welche der in der Fig. 2 gezeigten X-Y-Ebene entspricht und welche im verbundenen Zustand des Verbindungssystems 10 parallel zur Bezugsebene des handlerseitigen Rahmens 20 angeordnet ist.

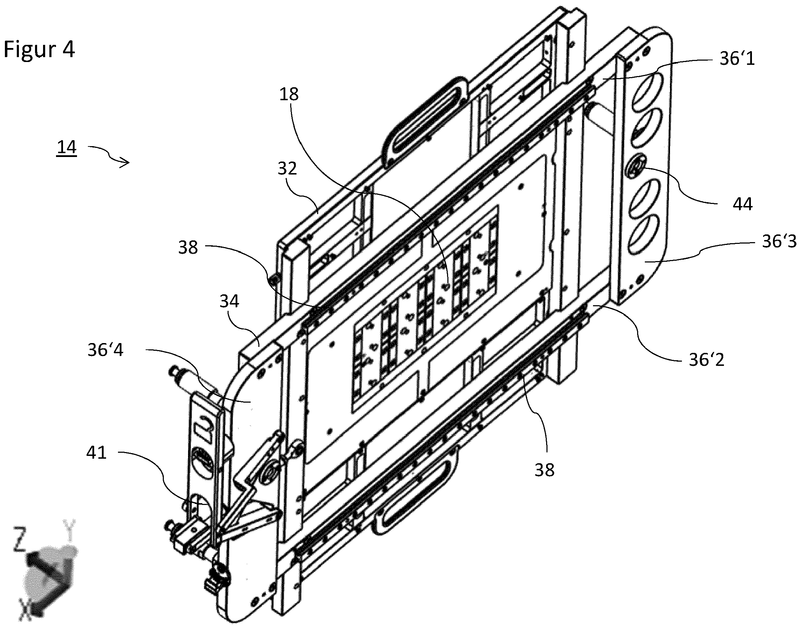

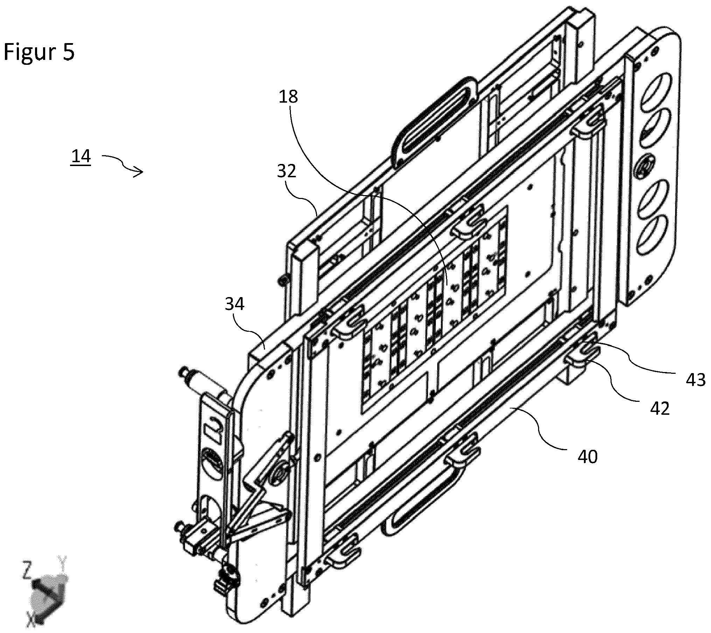

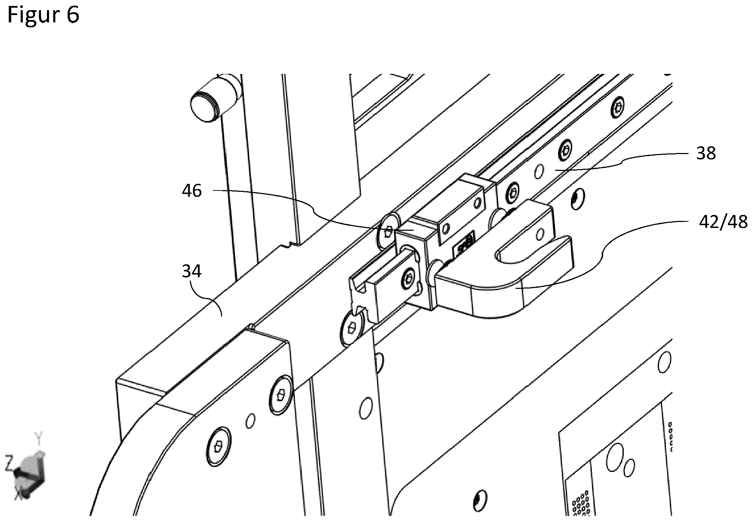

Wie in Fig. 4 gezeigt ist an dem Versteifungselement 32 ein erster testerseitiger Rahmen 34 angeordnet bzw. das Versteifungselement 32 ist mit dem ersten testerseitigen Rahmen 34 verbunden. Der erste testerseitige Rahmen 34 weist eine im Wesentlichen rechteckige Form auf und eine Rahmenöffnung, durch welche im verbundenen Zustand die testerseitige Leiterplatte 18 die handlerseitige Leiterplatte 16 kontaktiert, insbesondere elektrisch kontaktiert. Ferner besteht der erste testerseitige Rahmen 34 aus vier Rahmenabschnitten 36'1-4, wobei zwei sich gegenüberliegende Rahmenabschnitte 36'1 und 36'2 des ersten testerseitigen Rahmens 34 jeweils ein schienenförmiges Führungselement 38 aufweisen. Wie in den Fig. 5 und 6 gezeigt, sind an den schienenförmigen Führungselementen 38 eine Vielzahl von testerseitigen Eingriffelementen 42 bewegbar angeordnet. Insbesondere zeigen Fig. 1 und 5 sechs testerseitige Eingriffelemente 42, die dazu ausgebildet sind, mit der entsprechenden handlerseitigen Eingriffelementen 26 in Eingriff zu gelangen. Drei testerseitige Eingriffelemente 42 sind dabei mittels des schienenförmigen Führungselements 38 am Rahmenabschnitt 36'1 des ersten testerseitigen Rahmens 34 angeordnet und drei andere testerseitige Eingriffelemente 42 am Rahmenabschnitt 36'2 des ersten testerseitigen Rahmens 34. Ferner ermöglichen die schienenförmigen Führungselemente 38 eine Bewegung der Vielzahl von testerseitigen Eingriffelementen 42 parallel zur Bezugsebene des ersten testerseitigen Rahmens 34, welche der dargestellten X-Y-Ebene entspricht.

Die Vielzahl von testerseitigen Eingriffelementen 42 ist dazu ausgebildet, zum Verbinden des Verbindungssystems 10 in Eingriff mit der Vielzahl von handlerseitigen Eingriffelementen 26 zu gelangen.

Wie in Fig. 5 gezeigt, ist an dem ersten testerseitigen Rahmen 34 ein zweiter testerseitiger Rahmen 40 angeordnet. Der zweite testerseitige Rahmen 40 weist eine im Wesentlichen rechteckige Form auf und umgibt eine Rahmenöffnung. Durch die Rahmenöffnung des zweiten testerseitigen Rahmens 40 ist es möglich, dass im verbundenen Zustand des Verbindungssystems 10, die testerseitige Leiterplatte 18 die handlerseitige Leiterplatte 16 kontaktiert, insbesondere elektrisch kontaktiert. Des Weiteren spannt der zweite testerseitige Rahmen 40 eine Bezugsebene auf, welche im Wesentlichen parallel zur dargestellten X-Y-Ebene liegt. Im verbundenen Zustand liegen die Bezugsebene des zweiten testerseitigen Rahmens 40 und die Bezugsebene des handlerseitigen Rahmens 12 im Wesentlichen parallel zueinander.

Ferner ist der zweite testerseitige Rahmen 40 verschiebbar in Bezug auf den ersten testerseitigen Rahmen 34 ausgebildet. Dazu kann die erste testerseitige Verbindungseinheit 14 ein Hebelelement 41 aufweisen, mit welchem der zweite testerseitige Rahmen 40 im Wesentlichen parallel zu dem ersten testerseitigen Rahmen 34 verschiebbar ist. Ferner weist der zweite testerseitige Rahmen 40 eine Vielzahl von Aussparungen 43 auf, durch welche die Vielzahl von testerseitigen Eingriffelementen 42 hindurchragt, insbesondere entgegen der Verbindungsrichtung V. Mit anderen Worten, der zweite testerseitige Rahmen 40 ist auf die Vielzahl von testerseitigen Eingriffelementen 42 aufgesteckt, so dass die Vielzahl von testerseitigen Eingriffelementen 42 zumindest abschnittsweise von dem zweiten testerseitigen Rahmen 40 umschlossen wird. Das Hebelelement 41 kann insbesondere als Kniehebel ausgebildet sein, welcher den ersten testerseitigen Rahmen 34 mit dem zweiten testerseitigen Rahmen 40 verbindet, wodurch beim Bewegen des Hebelelements 41 der zweite testerseitige Rahmen 40 gegenüber dem ersten testerseitigen Rahmen 34 bewegt wird.

Durch Bewegen des zweiten testerseitigen Rahmens 40, werden die Vielzahl von testerseitigen Eingriffelementen auf den schienenförmigen Führungselementen 38 bewegt. D.h., der zweite testerseitige Rahmen 40 ist dazu ausgebildet, die Vielzahl von testerseitigen Eingriffelementen 42 zu führen, sodass zum Verbinden des Verbindungssystems 10, die Vielzahl von testerseitigen Eingriffelementen 42 mit den handlerseitigen Eingriffelementen 26 in Eingriff gelangt.

Wie in Fig. 6 gezeigt, besteht ein Eingriffelement 42 der Vielzahl von testerseitigen Eingriffelementen 42 aus einem Träger 46, der beweglich an einem schienenförmigen Führungselement 38 angeordnet ist, und einem hakenförmigen Abschnitt 48, welcher dazu ausgebildet ist mit einem entsprechenden handlerseitigen Eingriffelement 26 in Eingriff zu gelangen. Insbesondere ist der hakenförmige Abschnitt 48 dazu ausgebildet, dass beim Verbinden des Verbindungssystems 10, die handlerseitige Verbindungseinheit 12 an die testerseitige Verbindungseinheit 14 herangezogen wird. Dazu kann der hakenförmige Abschnitt 48 derart ausgebildet sein, dass die durch den hakenförmigen Abschnitt 48 gebildete Öffnung sich ausgehend von dem offenen Ende des hakenförmigen Abschnitts 48 verjüngt. Ferner ist im verbundenen Zustand der hakenförmige Abschnitt 48 zumindest abschnittsweise in einer entsprechenden handlerseitigen Aussparung 28 angeordnet, so dass der hakenförmige Abschnitt 48 in ein entsprechendes handlerseitiges Eingriffelement 26 eingreift.

Zum Durchführen eines Tests einer zu testenden elektrischen Einheit wird die testerseitige Verbindungseinheit 14 an einem Tester bzw. an einer Testvorrichtung (nicht gezeigt) angeordnet. Dazu können an dem ersten testerseitigen Rahmen 34 eine Vielzahl von Verbindungselementen 50 angeordnet sein, mit denen eine schnell lösbare Verbindung zwischen dem Tester und der testerseitigen Verbindungseinheit 14 realisiert werden kann.

Wie in Fig. 7 gezeigt, sind im verbundenen Zustand des Verbindungssystems 10, die testerseitige Leiterplatte 18 und die handlerseitigen Leiterplatte 16 miteinander kontaktiert, insbesondere elektrische kontaktiert. Ferner ist die zu testende Einheit mittels der handlerseitigen Verbindungseinheit 12 mit der testerseitigen Leiterplatte 18 verbunden, sodass der Tester einen Funktionstest der zu testenden Einheit durchführen kann.

Insbesondere ist die testerseitige Leiterplatte 18 als universelle Leiterplatte ausgebildet und muss bei einem Wechsel der zu testenden Einheit durch eine nicht baugleiche zu testende Einheit nicht gewechselt werden. Vielmehr bleibt die testerseitige Leiterplatte 18 an der testerseitigen Verbindungseinheit 14 angeordnet. Des Weiteren stellt die handlerseitige Leiterplatte 18 eine Art Schnittstelle zwischen der (universellen) testerseitigen Leiterplatte 18 und der zu testende elektrischen Einheit bereit. Bei einem Wechsel der zu testende Einheit, ist es daher lediglich erforderlich, die handlerseitige Verbindungseinheit 12 derart umzurüsten, dass die handlerseitige Leiterplatte 16 durch eine entsprechende handlerseitige Leiterplatte 16 ersetzt wird, welche die universelle testerseitige Leiterplatte 14 und die zu testende elektrische Einheit unterstützt.

Bei einem Wechsel der zu testenden Einheit bzw. des Handlers, kann somit das Umrüsten des Testers entfallen. Insbesondere können bereits vorbereitete Handler direkt mit dem Tester verbunden werden, ohne dass dieser für eine Testdurchführung umgerüstet werden muss.

### Bezugszeichenliste

- 10: Verbindungssystem
- 12: handlerseitige Verbindungseinheit
- 14: testerseitige Verbindungseinheit
- 16: handlerseitige Leiterplatte
- 17: Anordnungsposition
- 18: testerseitige Leiterplatte
- 20: handlerseitiger Rahmen
- 21'1-4: Rahmenabschnitte (handlerseitiger Rahmen)
- 22: handlerseitiges Unterstützungselement
- 24: handlerseitige elektrische Verbindungsmittel
- 26: Vielzahl handlerseitiger Eingriffelemente
- 28: handlerseitige Aussparung
- 30: Führungsmittel
- 32: Versteifungselement
- 34: erster testerseitiger Rahmen
- 36'1-4: Rahmenabschnitte des ersten testerseitigen Rahmens
- 38: schienenförmiges Führungselement
- 40: zweiter testerseitiger Rahmen
- 41: Hebelelement
- 42: Vielzahl testerseitiger Eingriffelemente
- 43: Aussparrungen zweiter testerseitiger Rahmen
- 44: Führungselemente
- 46: Trägerelement
- 48: hakenförmiger Abschnitt
- 50: Verbindungselemente
- V: Verbindungsrichtung

## Patentansprüche

1. Testerseitige Verbindungseinheit (14) für einen Testhandler, insbesondere einen Halbleitertesthandler, zum Verbinden mit einer handlerseitigen Verbindungseinheit (12), aufweisend:
- einen ersten testerseitigen Rahmen (34), der eine Vielzahl von testerseitigen Eingriffelementen (42) aufweist, welche dazu ausgelegt ist, mit einer Vielzahl von handlerseitigen Eingriffelementen (26) in Eingriff zu gelangen,
wobei die Vielzahl von testerseitigen Eingriffelementen (42) beweglich an dem ersten testerseitigen Rahmen (34) ausgebildet ist, und
wobei zum Verbinden der testerseitigen Verbindungseinheit (14) mit der handlerseitigen Verbindungseinheit (12), die Vielzahl von testerseitigen Eingriffelementen (42) derart führbar ist, dass die Vielzahl von testerseitigen Eingriffelementen (42) mit der Vielzahl von handlerseitigen Eingriffelementen (26) in Eingriff gelangt; **dadurch gekennzeichnet, dass** die testerseitige Verbindungseinheit weiter aufweist:
- einen zweiten testerseitigen Rahmen (40), der gegenüber dem ersten testerseitigen Rahmen (34) im Wesentlichen parallel verschiebbar ausgebildet ist,
wobei der zweite testerseitige Rahmen (40) eine Vielzahl von Aussparungen (43) aufweist, durch welche die Vielzahl von testerseitigen Eingriffelementen (42) hindurchragt,
wobei die Vielzahl von testerseitigen Eingriffelementen (42) durch den zweiten testerseitigen Rahmen (40) führbar ist, und
wobei zum Verbinden der testerseitigen Verbindungseinheit (14) mit der handlerseitigen Verbindungseinheit (12), der zweite testerseitige Rahmen (40) in eine Sicherungsposition bewegbar ist und die Vielzahl von testerseitigen Eingriffelementen (42) mittels des zweiten testerseitigen Rahmens (40) derart in die gleiche Richtung führbar ist, dass die Vielzahl von testerseitigen Eingriffelementen (42) mit der Vielzahl von handlerseitigen Eingriffelementen (26) in Eingriff gelangt.

2. Verbindungssystem (10) für einen Testhandler, insbesondere einen Halbleitertesthandler, aufweisend:
- eine testerseitige Verbindungseinheit (14) nach Anspruch 1;
- eine handlerseitige Verbindungseinheit (12) zur Anordnung an einem Handler, wobei die testerseitige Verbindungseinheit (14) und die handlerseitige Verbindungseinheit (12) miteinander verbindbar sind;
wobei die handlerseitige Verbindungseinheit (12) aufweist:
- einen handlerseitigen Rahmen (20), der eine Vielzahl von handlerseitigen Eingriffelementen (26) aufweist.

3. Verbindungssystem (10) nach Anspruch 2, wobei der handlerseitige Rahmen ein handlerseitiges Führungsmittel (30) aufweist, welches beim Verbinden des Verbindungssystems (10) in ein an der testerseitigen Verbindungseinheit (14) angeordnetes testerseitiges Führungselement (44) einführbar ist.

4. Verbindungssystem (10) nach Anspruch 2 oder 3, wobei die testerseitige Verbindungseinheit (14) ein Hebelelement (41) aufweist, welches dazu ausgebildet ist, den zweiten testerseitigen Rahmen (40) gegenüber dem ersten testerseitigen Rahmen (34) zu verschieben.

5. Verbindungssystem (10) nach einem der Ansprüche 2 bis 4, wobei die testerseitige Verbindungseinheit (14) eine Vielzahl von testerseitigen Verbindungselementen (50) aufweist, die dazu ausgelegt ist, die testerseitige Verbindungseinheit (14) mit einem Tester zu verbinden; und/oder
wobei die testerseitige Verbindungseinheit (14) dazu ausgelegt ist, eine testerseitige Leiterplatte (18) aufzunehmen und die handlerseitige Verbindungseinheit (12) dazu ausgelegt ist, eine handlerseitige Leiterplatte (16) aufzunehmen, und wobei im verbundenen Zustand des Verbindungssystems (10) die testerseitige Leiterplatte (18) und die handlerseitige Leiterplatte (16) sich elektrisch kontaktieren, und optional weiter aufweisend ein testerseitiges Versteifungselement (32), welches an dem ersten testerseitigen Rahmen (34) angeordnet ist und dazu ausgelegt ist, die testerseitige Leiterplatte (18) aufzunehmen.

6. Verbindungssystem (10) nach einem der Ansprüche 2 bis 5, wobei die Vielzahl von testerseitigen Eingriffelementen (42) derart ausgebildet ist, dass beim Verbinden des Verbindungssystems (10), die handlerseitige Verbindungseinheit (12) an die testerseitige Verbindungseinheit (14) heranziehbar ist.

7. Verwenden eines Verbindungssystems (10) nach einem der vorangegangenen Ansprüche 2-6 zum Verbinden eines Testhandlers, insbesondere eines Halbleitertesthandlers.

8. Verfahren zum Verbinden eines Testhandlers, insbesondere eines Halbleitertesthandlers, mittels eines Verbindungssystems (10) nach einem der Ansprüche 2-6, aufweisend:
- Anordnen der handlerseitigen Verbindungseinheit (12) an der testerseitigen Verbindungseinheit (14); und
- Führen der Vielzahl von testerseitigen Eingriffelementen (42) derart, dass die Vielzahl von testerseitigen Eingriffelementen (42) mit der Vielzahl von handlerseitigen Eingriffelementen (26) in Eingriff gelangt.

## Claims

1. Tester-side connection unit (14) for a test handler, in particular a semiconductor test handler, for connection to a handler-side connection unit (12), comprising:
- a first tester-side frame (34), which comprises a plurality of tester-side engagement elements (42), which is adapted to engage with a plurality of handler-side engagement elements (26),
wherein the plurality of tester-side engagement elements (42) is movably formed on the first tester-side frame (34), and
wherein, in order to connect the tester-side connection unit (14) to the handler-side connection unit (12), the plurality of tester-side engagement elements (42) can be guided in such a way that the plurality of tester-side engagement elements (42) engages with the plurality of handler-side engagement elements (26); **characterized in that** the tester-side connection unit further comprises:
- a second tester-side frame (40) designed to be slidable substantially in parallel relative to the first tester-side frame (34),
wherein the second tester-side frame (40) comprises a plurality of recesses (43), through which the plurality of tester-side engagement elements (42) protrude,
wherein the plurality of tester-side engagement elements (42) can be guided by the second tester-side frame (40), and
wherein, in order to connect the tester-side connection unit (14) to the handler-side connection unit (12), the second tester-side frame (40) is movable to a securing position and the plurality of tester-side engagement elements (42) can be guided by means of the second tester-side frame (40) in such a way in the same direction that the plurality of tester-side engagement elements (42) engages with the plurality of handler-side engagement elements (26).

2. Connection system (10) for a test handler, in particular a semiconductor test handler, comprising:
- a tester-side connection unit (14) according to claim 1;
- a handler-side connection unit (12) for arrangement on a handler,
wherein the tester-side connection unit (14) and the handler-side connection unit (12) are connectable to one another;
wherein the handler-side connection unit (12) comprises:
- a handler-side frame (20), which comprises a plurality of handler-side engagement elements (26).

3. Connection system (10) according to claim 2, wherein the handler-side frame comprises a handler-side guide means (30) insertable into a tester-side guide element (44) arranged on the tester-side connection unit (14) when connecting the connection system (10).

4. Connection system (10) according to claim 2 or 3, wherein the tester-side connection unit (14) comprises a lever element (41) designed to slide the second tester-side frame (40) relative to the first tester-side frame (34).

5. Connection system (10) according to any one of claims 2 to 4, wherein the tester-side connection unit (14) comprises a plurality of tester-side connection elements (50), which is adapted to connect the tester-side connection unit (14) to a tester; and/or
wherein the tester-side connection unit (14) is adapted to receive a tester-side circuit board (18) and the handler-side connection unit (12) is adapted to receive a handler-side circuit board (16), and wherein, in the connected state of the connection system (10), the tester-side circuit board (18) and the handler-side circuit board (16) electrically contact one another, and optionally further comprising a tester-side reinforcing element (32) arranged on the first tester-side frame (32) and adapted to receive the tester-side circuit board (18).

6. Connection system (10) according to any one of claims 2 to 5, wherein the plurality of tester-side engagement elements (42) is designed in such a way that, when connecting the connection system (10), the handler-side connection unit (12) can be brought onto the tester-side connection unit (14).

7. Use of a connection system (10) according to any one of claims 2-6 for connecting a test handler, in particular a semiconductor test handler.

8. Method for connecting a test handler, in particular a semiconductor test handler, by means of a connection system (10) according to any one of claims 2-6, comprising:
- arranging the handler-side connection unit (12) on the tester-side connection unit (14); and
- guiding the plurality of tester-side engagement elements (42) in such a way that the plurality of tester-side engagement elements (42) engages with the plurality of handler-side engagement elements (26).

## Revendications

1. Unité de liaison côté testeur (14) pour un gestionnaire de test, en particulier un gestionnaire de test de semi-conducteurs, destinée à être reliée à une unité de liaison côté gestionnaire (12), présentant :
- un premier châssis côté testeur (34), qui présente une pluralité d'éléments de prise côté testeur (42), qui est conçue pour parvenir en prise avec une pluralité d'éléments de prise côté gestionnaire (26),
dans lequel la pluralité d'éléments de prise côté testeur (42) est réalisée de manière mobile sur le premier châssis côté testeur (34), et
dans lequel pour relier l'unité de liaison côté testeur (14) à l'unité de liaison côté gestionnaire (12), la pluralité d'éléments de prise côté testeur (42) peut être guidée de telle manière que la pluralité d'éléments de prise côté testeur (42) parvient en prise avec la pluralité d'éléments de prise côté gestionnaire (26), **caractérisée en ce que** l'unité de liaison côté testeur présente par ailleurs :
- un deuxième châssis côté testeur (40), qui est réalisé de manière à pouvoir être coulissé de manière sensiblement parallèle par rapport au premier châssis côté testeur (34),
dans lequel le deuxième châssis côté testeur (40) présente une pluralité d'évidements (43), par lesquels la pluralité d'éléments de prise côté testeur (42) dépasse de part en part,
dans lequel la pluralité d'éléments de prise côté testeur (42) peut être guidée par le deuxième châssis côté testeur (40), et
dans lequel pour relier l'unité de liaison côté testeur (14) à l'unité de liaison côté gestionnaire (12), le deuxième châssis côté testeur (40) peut être déplacé dans une position de blocage et la pluralité d'éléments de prise côté testeur (42) peut être guidée au moyen du deuxième châssis côté testeur (40) de telle manière dans la même direction que la pluralité d'éléments de prise côté testeur (42) parvient en prise avec la pluralité d'éléments de prise côté gestionnaire (26).

2. Système de liaison (10) pour un gestionnaire de test, en particulier un gestionnaire de test de semi-conducteurs, présentant :
- une unité de liaison côté testeur (14) selon la revendication 1 ;
- une unité de liaison côté gestionnaire (12) destinée à être disposée sur un gestionnaire,
dans lequel l'unité de liaison côté testeur (14) et l'unité de liaison côté gestionnaire (12) peuvent être reliées l'une à l'autre ;
dans lequel l'unité de liaison côté gestionnaire (12) présente :
- un châssis côté gestionnaire (20), qui présente une pluralité d'éléments de prise côté gestionnaire (26).

3. Système de liaison (10) selon la revendication 2, dans lequel le châssis côté gestionnaire présente un moyen de guidage côté gestionnaire (30), lequel peut être introduit dans un élément de guidage côté testeur (44) disposé sur l'unité de liaison côté testeur (14) lors de la liaison du système de liaison (10).

4. Système de liaison (10) selon la revendication 2 ou 3, dans lequel l'unité de liaison côté testeur (14) présente un élément de levier (41), lequel est réalisé pour faire coulisser le deuxième châssis côté testeur (40) par rapport au premier châssis côté testeur (34).

5. Système de liaison (10) selon l'une quelconque des revendications 2 à 4, dans lequel l'unité de liaison côté testeur (14) présente une pluralité d'éléments de liaison côté testeur (50), qui est conçue pour relier l'unité de liaison côté testeur (14) à un testeur ; et/ou
dans lequel l'unité de liaison côté testeur (14) est conçue pour recevoir une carte de circuits imprimés côté testeur (18) et l'unité de liaison côté gestionnaire (12) est conçue pour recevoir une carte de circuits imprimés côté gestionnaire (16), et dans lequel dans l'état relié du système de liaison (10), la carte de circuits imprimés côté testeur (18) et la carte de circuits imprimés côté gestionnaire (16) établissent un contact électrique entre elles, et présentant par ailleurs en option un élément de renfort côté testeur (32), lequel est disposé sur le premier châssis côté testeur (32) et est conçu pour recevoir la carte de circuits imprimés côté testeur (18).

6. Système de liaison (10) selon l'une quelconque des revendications 2 à 5, dans lequel la pluralité d'éléments de prise côté testeur (42) est réalisée de telle manière que lors de la liaison du système de liaison (10), l'unité de liaison côté gestionnaire (12) peut être amenée sur l'unité de liaison côté testeur (14).

7. Utilisation d'un système de liaison (10) selon l'une quelconque des revendications 2-6 pour relier un gestionnaire de test, en particulier un gestionnaire de test de semi-conducteurs.

8. Procédé pour relier un gestionnaire de test, en particulier un gestionnaire de test de semi-conducteurs, au moyen d'un système de liaison (10) selon l'une quelconque des revendications 2-6, présentant :
- la disposition de l'unité de liaison côté gestionnaire (12) sur l'unité de liaison côté testeur (14) ; et
- le guidage de la pluralité d'éléments de prise côté testeur (42) de telle manière que la pluralité d'éléments de prise côté testeur (42) parvient en prise avec la pluralité d'éléments de prise côté gestionnaire (26).
